# EUROPÄISCHE PATENTSCHRIFT

(11) **EP 0 970 442 B1**
(45) Veröffentlichungstag und Bekanntmachung des Hinweises auf die Patenterteilung: **16.06.2004**
(21) Anmeldenummer: 98909326.5
(22) Anmeldetag: 04.02.1998
(51) Int. Cl.: G07C 9/00, H03J 9/02

(54) **VORRICHTUNG ZUR BEEINFLUSSUNG DES BETRIEBSZUSTANDES EINES ELEKTRONISCHEN GERÄTS**
DEVICE FOR INFLUENCING THE OPERATING STATUS OF AN ELECTRONIC APPLIANCE
DISPOSITIF POUR INFLUENCER L'ETAT DE FONCTIONNEMENT D'UN APPAREIL ELECTRONIQUE

(30) Priorität: 21.03.1997 DE 19711788
(43) Veröffentlichungstag der Anmeldung: 12.01.2000
(73) Patentinhaber: ROBERT BOSCH GMBH, 70442 Stuttgart (DE)
(72) Erfinder: GRÖGER, Klaus-Erwin, D-31199 Diekholzen (DE)
(86) Internationale Anmeldenummer: PCT/DE1998/000303
(87) Internationale Veröffentlichungsnummer: WO 1998/043209

(56) Entgegenhaltungen:
- EP-A- 0 744 627
- DE-A- 3 544 370
- FR-A- 2 615 306

## Beschreibung

### Stand der Technik

Die Erfindung geht von einer Vorrichtung zur Beeinflussung des Betriebszustandes eines elektronischen Geräts unter Verwendung eines Transponders nach der Gattung des Hauptanspruchs aus.

Aus der Gebrauchsmusterschrift DE 295 14 056 ist eine Einrichtung zum Schutz einer Audioeinrichtung vor unbefugter Benutzung bekannt, bei der nach Entfernen eines mit der Audioeinrichtung lösbar verbundenen Mobilteils die Funktion der Audioeinrichtung unterbrochen und nach Wiederansetzen des Mobilteils erst dann wieder freigegeben wird, wenn von dem zu diesem Zweck im Mobilteil angeordneten Transponder ein von der Audioeinrichtung als berechtigt akzeptierter Zugangscode abgestrahlt wird.

Weiterhin sind aus dem Bereich der Unterhaltungselektronik zur Bedienung von z. B. Fernsehgeräten, Videorecordern und Audioanlagen Infrarotfernbedienungen bekannt, über die zumindest ein Teil der verfügbaren Funktionen des betroffenen Geräts fernsteuerbar sind.

DE-A-35 44 370 betrifft ein System zur Fernbedienung z.B. eines Fernsehempfängers mit Hilfe von Lichtstrahlen, die von Gebern des Fernsehempfängers zu einem Mobilteil ausgesandt werden, an einer Spiegelfolie des Mobilteils (bar-)codiert reflektiert werden und auf Fühler des Fernsehempfängers wirken, um eine vom Bediener gewünschte Funktion in dem Empfänger auszulösen.

EP-A-0 744 627 befaßt sich mit einem Transponder zur Übermittlung veränderlicher physikalischer Parameter, z.B. eines Reifendrucks.

FR-A-2 615 306 beschreibt ein System zur Fernidentifizierung von Personen, z.B. Wachleuten, die Rundgänge in einem überwachten Gebiet durchführen und sich dabei an verschiedenen Meldepunkten meiden müssen, um zu belegen, daß sie eine vorgegebene Runde tatsächlich gegangen sind. Zur Dateneingabe verwenden die Wachleute kontaktlose Mobilgeräte, die über eine Tastatur verfügen. Ein geheimer Code kennzeichnet das Mobilgerät. Mittels der Tastatur und einer alphanumerischen Anzeige kann der betreffende Wachmann einen Dialog mit der Zentralstelle der Terminals führen.

### Vorteile der Erfindung

Die erfindungsgemäße Vorrichtung mit den Merkmalen des Hauptanspruchs hat den Vorteil, daß ein mit einem Transponder versehenes Mobilteil über eine reine Diebstahlsicherung hinaus auch als Fernbedienung zur Steuerung elektronischer Geräte verwendbar ist.

Gegenüber bekannten Infrarotfernbedienungen hat die erfindungsgemäße Vorrichtung den Vorteil, daß durch Verwendung eines Transponders Batterien zur Energieversorgung des Mobilteils entbehrlich sind. Dies wirkt sich in einer Gewichts- und Volumenreduktion des Mobilteils aus, außerdem entfällt die Entsorgung der umweltunverträglichen Altbatterien.

Ein weiterer Vorteil der vorgeschlagenen Lösung liegt darin, daß eine präzise Ausrichtung des Mobilteils auf den geräteseitigen Empfänger nicht notwendig ist, da die Übertragung der vom Mobilteil abgestrahlten elektromagnetischen Wellen zum Empfänger im Gegensatz zu bekannten Infrarotfernbedienungen auch ohne Sichtkontakt funktioniert.

Außerdem werden durch die Unempfindlichkeit der Vorrichtung gegen Lichteinfall Fehlbedienungen des zu bedienenden Geräts in Folge von Streulichteinfall vermieden.

Von Vorteil ist es weiterhin, daß die den Transponder erregende Schwingung und das Sendesignal des Transponders im ständigen Wechsel abgestrahlt werden. Auf diese Weise können erregende Schwingung und Sendesignal auf der gleichen Sendefrequenz übertragen werden, wodurch sowohl der empfänger- wie auch der transponderseitige Schwingkreis zum Senden und Empfangen der elektromagnetischen Schwingungen auf dieselbe Frequenz optimiert werden können.

Im Hinblick auf die hinsichtlich elektromagnetischer Verträglichkeit elektronischer Anlagen geltenden Vorschriften ist es von Vorteil, Sendefrequenz und -leistung so aufeinander abzustimmen, daß die Ausbreitung der den Transponder erregenden oder der vom Transponder abgestrahlten Schwingungen auf den Raum beschränkt ist, indem sich das zu bedienende Gerät befindet.

### Zeichnungen

Ausführungsbeispiele der Erfindung sind in den Zeichungen dargestellt und werden in der nachfolgenden Beschreibung näher erläutert.

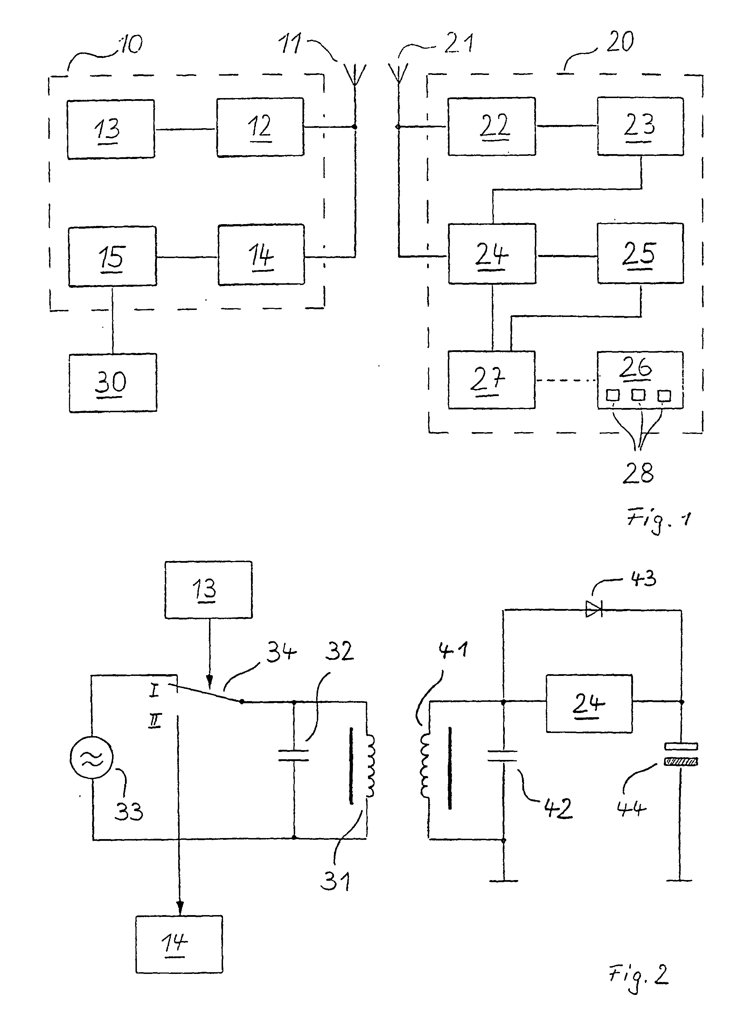

Es zeigen Figur 1 ein Blockschaltbild einer erfindungsgemäßen Vorrichtung und Figur 2 ein vorteilhaftes Ausführungsbeispiel zur Realisierung der erfindungsgemäßen Vorrichtung.

### Beschreibung eines Ausführungsbeispiels

Die erfindungsgemäße Vorrichtung wird im folgenden am Beispiel eines Autoradios erläutert, ist jedoch nicht auf dieses Beispiel beschränkt, sondern allgemein auf elektronische Geräte im Bereich der Unterhaltungselektronik wie z. B. Fernsehgeräte, Videorecorder, Audioanlagen, aber auch auf elektronische Geräte allgemein anwendbar.

In Figur 1 ist ein Blockschaltbild der erfindungsgemäßen Vorrichtung, bestehend aus einem Mobilteil 20 und einer Sende- und Empfangseinrichtung 10 dargestellt, die wiederum mit dem zu beeinflussenden elektronischen Gerät 30, im vorliegenden Fall einem Autoradio, in Verbindung steht.

Die Sende- und Empfangseinrichtung 10 umfaßt eine Sendeeinheit 12 zur Erzeugung einer hochfrequenten elektromagnetischen Schwingung zur Erregung des im Mobilteil 20 angeordneten Transponders 22 bis 25, im folgenden auch kurz als Erregerschwingung bezeichnet, die über die angeschlossene Antenne 11 abgestrahlt wird. Zur Steuerung der Sendevorgänge ist die Sendeeinheit 12 mit einer Steuereinheit 13 verbunden.

Die Sende- und Empfangseinrichtung 10 umfaßt weiterhin eine ebenfalls mit der Antenne 11 verbundene Empfangseinheit 14, die über die zum Empfang und zur Demodulation der vom Transponder abgestrahlten modulierten elektromagnetischen Schwingung, im folgenden kurz als Sendesignal bezeichnet, verfügt. Das am Ausgang der Empfangseinheit 14 anstehende demodulierte Empfangssignal ist einer Auswerteeinheit 15 zur Zuordnung von Steuerbefehlen und Funktionen zugeführt, mit denen das mit der Sende- und Empfangseinrichtung 10 verbundene elektronische Gerät 30 gesteuert wird.

Das Mobilteil 20 umfaßt eine weitere Antenne 21 zum Empfang der von der Sende- und Empfangseinrichtung 10 abgestrahlten Erregerschwingung, die mit einer Schaltung 22 zur Rückgewinnung der in der Erregerschwingung enthaltenen Energie verbunden ist. Die Energierückgewinnungsschaltung 22 ist ihrerseits wiederum mit einem Energiespeicher 23 verbunden.

Das Mobilteil 20 umfaßt weiterhin eine Bedienelemente 28 wie z. B. Drucktasten umfassende Bedieneinheit 26, über die in einer Codegenerierung 27 erzeugte Codes auswählbar sind. Die Bedieneinheit 26 steht dazu über eine weitere Steuereinheit 25 mit der Codegenerierung 27 in Verbindung. Die in der Codegenerierung 27 erzeugten Codes werden einer weiteren Sendeeinheit 24 zur Erzeugung einer mit dem von der Codegenerierung 27 zugeführten Code modulierten elektromagnetischen Schwingung zugeführt, die über die weitere Antenne 21 abgestrahlt wird.

Die Codegenerierung 27 umfaßt im vorliegenden Fall einen Speicher, in dem eine Anzahl von Codes abgelegt ist. Dieser Speicher ist durch Bedienelemente der Bedieneinheit 26 adressierbar, so daß in Abhängigkeit der Betätigung eines oder mehrerer Bedienelemente 28 der Bedieneinheit 26 bestimmte Codes auswählbar sind.

Im vorliegenden Ausführungsbeispiel ist es vorgesehen, daß die von der weiteren Antenne 21 abgestrahlte Schwingung direkt mit einem aus dem Speicher ausgelesenen Code moduliert ist.

Bei einem weiteren Ausführungsbeispiel umfaßt die Codegenerierung einen Verschlüsselungsalgorithmus, mit dem die aus dem Speicher ausgelesenen Codes verschlüsselt werden, so daß das Sendesignal des Transponders mit einem verschlüsselten Code moduliert wird.

Zur Bereitstellung der zur Erzeugung des Sendesignals erforderlichen Energie ist die weitere Sendeeinheit 24 mit dem Energiespeicher 23 verbunden.

Die Funktionsweise der erfindungsgemäßen Vorrichtung wird im folgenden unter Bezug auf das in Figur 2 dargestellte Ausführungsbeispiel der erfindungsgemäßen Vorrichtung beschrieben.

Zur Abfrage von Steuercodes, die durch Tastenbetätigung am Mobilteil 20 ausgewählt werden, wird der Transponder 22 bis 25 des Mobilteils 20 durch eine von der Leseeinheit 10 erzeugte Erregerschwingung angeregt. Zur Abfrage von durch Tastenbetätigung am Mobilteil 20 generierbaren Steuercodes sendet die Sendeeinheit 12 der Leseeinheit 10 über die Antenne 11 einen eine vorgegebene Zeitdauer, im vorliegenden Beispiel ca. 50 mSek. andauernden elektromagnetischen hochfrequenten Impuls, die sogenannte Erregerschwingung. Dazu wird ein auf einer Frequenz von beispielsweise 125 kHz arbeitender Oszilator 33 über einen von der Steuereinheit 13 betätigten Schalter 34, der hierfür in eine erste Schaltstellung 1 gebracht wird, für die Dauer des Erregerimpulses von 50 mSek. mit einem aus Kondensator 32 und als Sendeantenne wirkender Spule 31 bestehenden Resonanzschwingkreis verbunden, dessen Resonanzfrequenz auf die Frequenz des Oszilators 33 abgestimmt ist.

Die von der Leseeinheit 10 abgestrahlte Erregerschwingung wird von der auf der gleichen Frequenz arbeitenden weiteren Antenne 21 in Form einer weiteren Spule 41 eines aus weiterer Spule 41 und weiterem Kondensator 42 bestehenden weiteren Schwingkreises des Mobilteils 20 aufgefangen. Das empfangene Wechselspannungssignal wird zur Energierückgewinnung mittels einer als Energierückgewinnungsschaltung 22 funktionierenden Diode 43 gleichgerichtet und die daraus resultierende Energie in dem Energiespeicher 23, im vorliegenden Ausführungsbeispiel als Kondensator 44 mit hoher spezifischer Kapazität, d.h. mit auf das Volumen bezogen hoher Kapazität ausgebildet, gespeichert.

Nach Abklingen der Erregerschwingung beginnt die Datenübertragung vom Mobilteil 20 zur Sende- und Empfangseinrichtung 10, d. h. das Mobilteil 20 strahlt über die weitere Antenne 21 eine mit einem über die Bedieneinheit 26 ausgewählten Code modulierte Schwingung ab. Dazu wird durch Betätigung eines Bedienelements 28 an der Bedieneinheit 26, im vorliegenden Fall einer Taste der dieser Taste zugeordnete Code aus dem Speicher 27 ausgelesen und der weiteren Sendeeinheit 24 zugeführt. Im einfachsten Fall geschieht dies dadurch, daß eine einer Taste zugeordnete Speicherzelle des Speichers 27 über einen über die Taste betätigten Tastschalter mit der Sendeeinheit 24 verbunden wird.

Im vorliegenden Ausführungsbeispiel erfolgt die Zuordnung der Betätigung eines Bedienelements 28 der Bedieneinheit 26 zu einem im Speicher 27 abgelegten Code jedoch über die weitere Steuereinheit 25.

Weiterhin wird über die weitere Steuereinheit 25 des Mobilteils 20 die weitere Sendeeinheit 24 aktiviert und die innerhalb der Sendeeinheit 24 erzeugte Schwingung von im vorliegenden Ausführungsbeispiel 125 KHz durch den aus dem Speicher 27 ausgelesenen Code moduliert. Im vorliegenden Fall wird als Modulationsart die Frequenzmodulation angewendet, wobei die Sendefrequenz durch den in binärer Form vorliegenden Code zwischen der Grundfrequenz von 125 KHz und 130 KHz umgetastet wird. Prinzipiell sind jedoch auch andere Modulationsarten wie Phasen- und Amplitudenmodulation und andere Frequenzen anwendbar.

Die zur Erzeugung des modulierten Sendesignals erforderliche Energie wird dem Energiespeicher 23 entnommen. Das von der Sendeeinheit 24 erzeugte modulierte Sendesignal wird dem weiteren Schwingkreis 41, 42 zugeführt und über die Spule 41 abgestrahlt.

Neben den beschriebenen Funktionen hat die weitere Steuereinheit 25 des Mobilteils 20 die Aufgabe, die Abstrahlung bzw. Erzeugung des Sendesignals auf den zur Übertragung des ausgewählten Codes erforderlichen Zeitrahmen zu beschränken. Auf diese Weise wird sichergestellt, daß im Übertragungszeitraum nur der zu übertragende Code abgestrahlt wird.

Das vom Mobilteil 20 abgestrahlte Sendesignal wird von der Antenne 11 der Sende- und Empfangseinrichtung 10 aufgenommen und über den steuerbaren Schalter 34, der in einer zweiten Schaltstellung eine Verbindung zwischen Schwingkreis 31, 32 und Empfangseinheit 14 herstellt, der Empfangseinheit 14 der Sende- und Empfangseinrichtung 10 zugeführt. Durch Demodulation des empfangenen Sendesignals wird in der Empfangseinheit 14 der übertragene Code isoliert und in der Auswerteeinheit 15 einem Steuerbefehl zur Steuerung des angeschlossenen elektronischen Geräts 30 zugeordnet.

Beim vorliegenden Ausführungsbeispiel ist es vorgesehen, daß die den Transponder des Mobilteils 20 erregende Schwingung und das vom Mobilteil 20 abgestrahlte Sendesignal auf der gleichen Frequenz von z. B. 125 kHz übertragen werden. Dazu ist es erforderlich, daß das Senden der Erregerschwingung von der Sende- und Empfangseinrichtung 10 und des Sendesignals vom Mobilteil 20 im ständigen Wechsel erfolgen.

Der Rhythmus, in dem das Absenden der Erregerschwingung und des Sendesignals erfolgt, wird durch die Steuerung 13 der Sende- und Empfangseinrichtung 10 vorgegeben. So wird der Schalter 34 durch die Steuerung 13 für eine vorgegebene Zeitdauer von z.B. 50 mSek. in seiner ersten Schaltstellung gehalten, so daß für diese Zeitdauer eine Erregerschwingung abgestrahlt wird. Nach Ablauf der vorgegebenen Zeitdauer wird der Schalter 34 durch die Steuerung 13 in eine zweite Schaltstellung gebracht, so daß nun die Antenne 11 der Sende- und Empfangseinrichtung 10 mit der Empfangseinheit 14 verbunden ist. Während des auf das Umschalten des Schalters 34 in die zweite Schaltstellung folgenden Zeitabschnitts wird von dem Mobilteil 20 das Sendesignal abgestrahlt.

Die Synchronisierung der mobilteilseitigen weiteren Sendeeinheit 24 auf das Umschalten des Schalters 34 erfolgt durch Bestimmung der mobilteilseitigen Antennenspannung in der weiteren Steuereinheit 25. Das Abfallen der Antennenspannung nach Empfang der Erregerschwingung zeigt an, daß der Schalter 34 in der Sende- und Empfangseinrichtung 10 umgeschaltet wurde und die Sende- und Empfangseinrichtung sich nun in Empfangsbereitschaft befindet, und wird zum Einleiten des mobilteilseitigen Sendevorgangs genutzt. Nach Ablauf einer zur Abstrahlung eines Sendesignals ausreichenden Zeitspanne, im vorliegenden Fall 20 mSek., wird die weitere Sendeeinheit 24 des Mobilteils 20 abgeschaltet und der Sendevorgang somit beendet.

Nach Ablauf der vorgegebenen Sendedauer, die in der Steuerung 13 der Sende- und Empfangseinrichtung bekannt ist, wird der Schalter 34 wieder in die erste Schaltstellung gebracht und erneut eine Erregerschwingung abgestrahlt.

## Patentansprüche

1. Anordnung zur Beeinflussung des Betriebszustandes eines elektronischen Geräts (30) mit
einem einen Transponder (22 - 25) umfassenden Mobilteil (20) zur Bedienung des elektronischen Geräts und
dem zu bedienenden Gerät (30), mit dem eine Sende- und Empfangseinrichtung (10) verbunden ist, die eine Sendeeinheit (12) zur Abstrahlung einer elektromagnetischen Schwingung zur Anregung eines Transponders (22 bis 25), eine Empfangseinheit (14) zum Empfang und zur Demodulation einer von dem Transponder (22 bis 25) abgestrahlten modulierten elektromagnetischen Schwingung und eine Auswerteeinheit (15) zur Umsetzung der demodulierten vom Transponder (22 bis 25) abgestrahlten elektromagnetischen Schwingung in Steuerbefehle zur Beeinflussung des Betriebszustandes des elektronischen Geräts (30) umfaßt,
**dadurch gekennzeichnet, daß** das Mobilteil (20) über eine
Codegenerierung (27) verfügt, in der eine Anzahl von Codes generierbar ist, die über mindestens eine am Mobilteil (20) angeordnete Bedieneinheit (26) zur Modulation der vom Transponder (22 bis 25) abgestrahlten elektromagnetischen Schwingung auswählbar sind, und daß durch Auswahl der Codes verschiedene Betriebszustände am elektronischen Gerät (30) auslösbar sind.

2. Anordnung nach Anspruch 1,
**dadurch gekennzeichnet, daß** die Abstrahlung der den Transponder (22 bis 25) erregenden elektromagnetischen Schwingung und der vom Transponder (22 bis 25) abgestrahlten elektromagnetischen Schwingung im ständigen Wechsel vorgesehen ist.

3. Anordnung nach einem der vorhergehenden Ansprüche,
**dadurch gekennzeichnet, daß** Sendeleistung/en und Sendefrequenz/en so gewählt sind, daß die Reichweite der von der Sendeeinheit (12) und vom Transponder (22 bis 25) abgestrahlten elektromagnetischen Schwingungen auf einen vorgegebenen zur Bedienung des elektrischen Geräts (30) notwendigen Umkreis der Sende- und Empfangseinheit (10) bzw. des Mobilteils (20) beschränkt ist.

4. Vorrichtung zur Bedienung eines elektronischen Geräts (30) in Form eines einen Transponder (22 - 25) umfassenden Mobilteils (20), **dadurch gekennzeichnet, daß** das Mobilteil (20) über eine Codegenerierung (27) verfügt, in der eine Anzahl von Codes generierbar ist, die über mindestens eine am Mobilteil (20) angeordnete Bedieneinheit (26) zur Modulation der vom Transponder (22 bis 25) abgestrahlten elektromagnetischen Schwingung auswählbar sind.

5. Vorrichtung nach Anspruch 4,
**dadurch gekennzeichnet, daß** die Bedieneinheit (26) des Mobilteils (20) über eine Vielzahl von Bedienelementen (28), vorzugsweise Tastschalter, verfügt, und daß jedem Bedienelement (28) ein in der Codegenerierung (27) erzeugter Code zugeordnet ist.

6. Vorrichtung nach Anspruch 4 oder 5, **gekennzeichnet durch** eine weitere Steuereinheit (25), die die Erzeugung bzw. Abstrahlung des Sendesignals auf den zur Übertragung des ausgewählten Codes erforderlichen Zeitraum beschränkt.

7. Fernbedienbares elektronisches Gerät (30) mit
- einer Sende- und Empfangseinrichtung (10), die eine Sendeeinheit (12) zur Abstrahlung einer elektromagnetischen Schwingung zur Anregung eines Transponders (22 bis 25) und eine Empfangseinheit (14) zum Empfang und zur Demodulation einer von dem Transponder (22 bis 25) abgestrahlten modulierten elektromagnetischen Schwingung umfaßt, und
- einer Auswerteeinheit (15) zur Umsetzung der demodulierten vom Transponder (22 bis 25) abgestrahlten codierten elektromagnetischen Schwingung in Steuerbefehle zur Beeinflussung des Betriebszustandes des elektronischen Geräts (30).

8. Elektronisches Gerät nach Anspruch 7, **dadurch gekennzeichnet, daß** das elektronische Gerät (30) ein Gerät der Unterhaltungselektronik, insbesondere eine Audioeinrichtung für Kraftfahrzeuge, ist.

## Claims

1. Arrangement for influencing the operating state of an electronic appliance (30) with
a mobile part (20), comprising a transponder (22 - 25), for operating the electronic appliance and with
the appliance (30) which is to be operated, to which a transmission and reception device (10) is connected which comprises a transmission unit (12) for radiating an electromagnetic oscillation in order to excite a transponder (22 to 25), a reception unit (14) for receiving and for demodulating a modulated electromagnetic oscillation radiated by the transponder (22 to 25), and an evaluation unit (15) for converting the demodulated electromagnetic oscillation radiated by the transponder (22 to 25) into control commands for influencing the operating state of the electronic appliance (30),
**characterized in that** the mobile part (20) has a code generation section (27) in which a number of codes can be generated which can be selected using at least one operating unit (26) arranged on a mobile part (20) for the purpose of modulating the electromagnetic oscillation radiated by the transponder (22 to 25), and **in that** by selecting the codes it is possible to trigger various operating states on the electronic appliance (30).

2. Arrangement according to Claim 1,
**characterized in that** the radiation of the electromagnetic oscillation which excites the transponder (22 to 25) and of the electromagnetic oscillation radiated by the transponder (22 to 25) is provided in constant alternation.

3. Arrangement according to one of the preceding claims,
**characterized in that** transmission power/s and transmission frequency/ies are chosen such that the range of the electromagnetic oscillations radiated by the transmission unit (12) and by the transponder (22 to 25) is limited to a prescribed radius for the transmission and reception unit (10) and for the mobile part (20), which radius is required for operating the electrical appliance (30).

4. Apparatus for operating an electronic appliance (30) in the form of a mobile part (20) which comprises a transponder (20 - 25), **characterized in that** the mobile part (20) has a code generation section (27) in which a number of codes can be generated which can be selected using at least one operating unit (26) arranged on the mobile part (20) for the purpose of modulating the electromagnetic oscillation radiated by the transponder (22 to 25).

5. Apparatus according to Claim 4,
**characterized in that** the operating unit (26) on the mobile part (20) has a multiplicity of operating elements (28), preferably momentary-contact switches, and **in that** each operating element (28) has an associated code which is generated in the code generation section (27).

6. Apparatus according to Claim 4 or 5, **characterized by** a further control unit (25) which limits the generation and radiation of the transmission signal to the period of time required for transmitting the selected code.

7. Remotely controllable electrical appliance (30) with
- a transmission and reception device (10) which comprises a transmission unit (12) for radiating an electromagnetic oscillation in order to excite a transponder (22 to 25), and a reception unit (14) for receiving and for demodulating a modulated electromagnetic oscillation radiated by the transponder (22 to 25), and
- an evaluation unit (15) for converting the demodulated coded electromagnetic oscillation radiated by the transponder (22 to 25) into control commands for influencing the operating state of the electronic appliance (30).

8. Electronic appliance according to Claim 7, **characterized in that** the electronic appliance (30) is a consumer electronics appliance, particularly an audio device for motor vehicles.

## Revendications

1. Dispositif pour influencer l'état de fonctionnement d'un appareil électronique (30) comportant une pièce mobile (20) comprenant un transpondeur (22 à 25) pour la commande de l'appareil électronique et de l'appareil (30) à exploiter à laquelle est relié un dispositif d'émission et de réception (10) qui comprend une unité d'émission (12) pour le rayonnement d'une oscillation électromagnétique pour l'excitation d'un transpondeur (22 à 25), une unité de réception (14) pour la réception et la démodulation d'une oscillation électromagnétique modulée rayonnée par le transpondeur (22 à 25) et une unité d'exploitation (15) pour la transposition de l'ondulation électromagnétique démodulée, rayonnée par le transpondeur (22 à 25), en instructions de commande pour influencer l'état de fonctionnement de l'appareil électronique (30),
**caractérisé en ce que**
la pièce mobile (20) dispose d'une génération de code (27) dans laquelle un certain nombre de codes peuvent être générés et être sélectionnés par au moins une unité de commande (26) disposée sur la partie mobile (20) pour la modulation de l'oscillation électromagnétique rayonnée par le transpondeur (22 à 25) et différents états de fonctionnement peuvent être déclenchés dans l'appareil électronique (30) par la sélection du code.

2. Dispositif selon la revendication 1,
**caractérisé en ce que**
le rayonnement de l'oscillation électromagnétique excitant le transpondeur (22 à 25) et l'oscillation électromagnétique rayonnée par le transpondeur (22 à 25) sont prévus en alternance permanente.

3. Dispositif selon l'une quelconque des revendications précédentes,
**caractérisé en ce que**
la ou les puissances d'émission et la ou les fréquences d'émission sont choisies de manière telle que la portée des oscillations électromagnétiques rayonnées par l'unité d'émission (12) et par le transpondeur (22 à 25) est limitée à la circonférence prédéfinie nécessaire à la commande de l'appareil électrique (30) de l'unité d'émission et de réception (10) ou de la pièce mobile (20).

4. Dispositif pour la commande d'un appareil électronique (30) sous la forme d'une pièce mobile (20) comprenant un transpondeur (22 à 25),
**caractérisé en ce que**
la pièce mobile (20) dispose d'une génération de codes (27) dans laquelle un certain nombre de codes peuvent être générés et être sélectionnés par au moins une unité de commande (26) disposée sur la pièce mobile (20) pour la modulation de l'oscillation électromagnétique rayonnée par le transpondeur (22 à 25).

5. Dispositif selon la revendication 4,
**caractérisé en ce que**
l'unité de commande (26) de la pièce mobile (20) dispose de nombreux éléments de commande (28), de préférence des commutateurs à touche, et à chaque élément de commande (28) est affecté un code créé dans la génération de codes (27).

6. Dispositif selon la revendication 4 ou 5,
**caractérisé par**
une autre unité de commande (25) qui limite la génération ou le rayonnement du signal d'émission à la durée nécessaire pour la transmission du code choisi.

7. Appareil électronique télécommandable (30) comportant
- un dispositif d'émission et de réception (10) qui comprend une unité d'émission (12) pour le rayonnement d'une oscillation électromagnétique pour l'excitation d'un transpondeur (22 à 25) et une unité de réception (14) pour la réception et la démodulation d'une oscillation électromagnétique modulée rayonnée par le transpondeur (22 à 25) et
- une unité d'exploitation (15) pour la transposition de l'ondulation électromagnétique codée, rayonnée du transpondeur (22 à 25) démodulée, pour influencer l'état de fonctionnement de l'appareil électronique (30).

8. Appareil électronique selon la revendication (7),
**caractérisé en ce que**
l'appareil électronique (30) est un appareil du domaine de l'électronique grand public, en particulier un dispositif audio pour véhicules automobiles.
